(19) Europäisches Patentamt / European Patent Office / Office européen des brevets

(11) **EP 3 489 711 A1**

(12) **EUROPEAN PATENT APPLICATION**

(43) Date of publication:
**29.05.2019 Bulletin 2019/22**

(21) Application number: **17202969.6**

(22) Date of filing: **22.11.2017**

(51) Int Cl.:
*G01S 7/03* (2006.01)          *G01S 7/35* (2006.01)
*G01S 13/34* (2006.01)        *H03L 7/08* (2006.01)
*H03L 7/097* (2006.01)        *H03L 7/18* (2006.01)
*H03L 7/181* (2006.01)        *G01S 7/02* (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Sivers Ima AB**
**164 29 Kista (SE)**

(72) Inventor: **Carlsson, Mats**
**174 46 Sundbyberg (SE)**

(74) Representative: **AWA Sweden AB**
**P.O. Box 665**
**831 27 Östersund (SE)**

(54) **FLL FOR A FREQUENCY MODULATED CONTINUOUS WAVE RADAR**

(57)    A frequency modulated continuous wave radar (100) comprising a transmitter device (102), a receiver device (105), and a chirp generator (101), connected with the transmitter device, wherein the chirp generator comprises a frequency locked loop, and a chirp controller connected with the frequency locked loop to control the shape of the chirp.

Fig. 3

**Description**

FIELD OF THE INVENTION

The present invention relates to the field of frequency modulated continuous wave radars.

BACKGROUND OF THE INVENTION

In a frequency modulated continuous wave (FMCW) radar, the frequency of the output signal follows a frequency ramp having two portions, i.e. a first portion and a following second portion. During the first portion the frequency is ramped up from a lower start frequency to a higher end frequency, or vice versa, and during the second portion the frequency of the output signal is returned to the start frequency. The duration of the first and second portions can be equal but usually the duration of the second portion, also called resetting portion, is significantly shorter. This combination of portions is continuously repeated. The frequency ramp of the first portion is called a chirp.

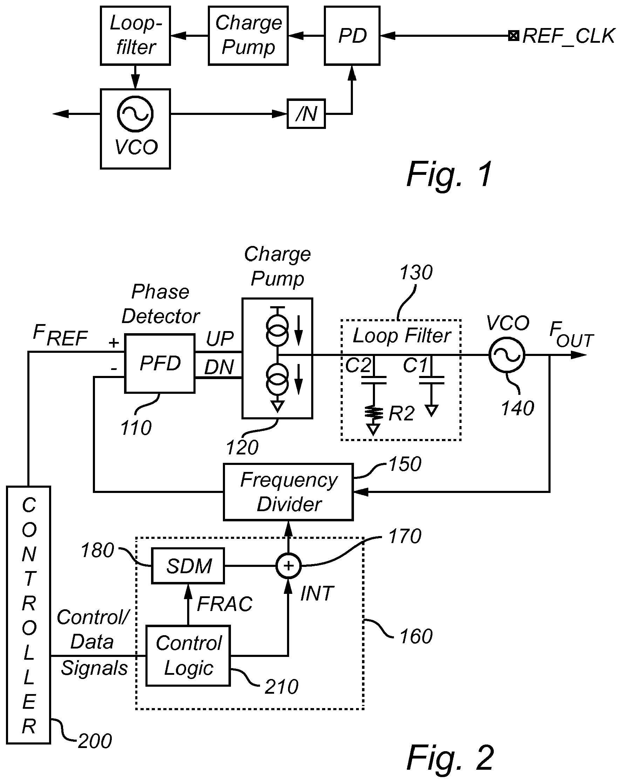

It is well known that the chirp can be generated by modulating a free running Voltage Controlled Oscillator (VCO). However, with a free running oscillator, the absolute frequency can vary significantly with temperature variations and manufacturing spread. To circumvent these issues, the VCO can be locked to a reference frequency by using a Phase Locked Loop (PLL) system, see Figure 1, generally comprising a phase detector, a charge pump, a loop filter, the VCO, and a frequency divider. In the PLL system, the frequency of the output signal from the VCO is divided to a lower frequency signal, the phase of which is compared with the phase of a reference clock with high absolute accuracy. The phases are compared in the phase detector, which provides an input to the charge pump, which in turn is generating a voltage to the VCO after filtering in the loop filter. With this closed loop feedback system, the frequency of the VCO becomes related to the frequency of the reference clock according the formula $f_{CVO}=f_{ref}*N$.

$f_{CVO} = f_{ref}*N$ The frequency division ratio can be either a fixed integer or a fraction of an integer, where fractions are used in so called Fractional-N Synthesizers. It is obvious that the VCO frequency can be modulated by varying the division ratio, which is used in recent prior art to generate the desired frequency ramp. One prior art PLL system is described in the patent US 8,638,139 B2. A copy of the block diagram of the system described in this patent is found in Figure 2. In the implementation of US 8,638,139, the Chirp generation is fully integrated on the chip and is carried out by modulating the division ratio by a Sigma-Delta modulated control signal (in 160).

SUMMARY OF THE INVENTION

It would be advantageous to simplify the generation of the output signal of the prior art FMCW radars.

To address this issue, in a first aspect of the invention there is presented a frequency modulated continuous wave radar comprising a transmitter device, a receiver device, and a chirp generator, connected with the transmitter device. The chirp generator comprises a frequency locked loop (FLL), and a chirp controller connected with the frequency locked loop to control the shape of the chirp. The generation of the output signal of this FMCW radar is simplified relative to the prior art FMCW radars in that the frequency locked loop has a simpler implementation than the phase locked loop. The present solution provides for a lower complexity of the circuitry, a smaller chip area, and a lower power consumption.

In accordance with an embodiment of the FMCW radar, the frequency locked loop comprises a $\Delta$-$\Sigma$ modulated frequency divider, and wherein the chirp controller is connected with the $\Delta$-$\Sigma$ modulated frequency divider.

In accordance with an embodiment of the FMCW radar, the frequency locked loop comprises a frequency to voltage converter, and the chirp controller is connected with the frequency to voltage converter.

In accordance with an embodiment of the FMCW radar, the frequency locked loop comprises a reference counter, which is arranged to receive a reference clock signal, and wherein the chirp controller is connected with the reference counter.

In accordance with an embodiment of the FMCW radar, the transmitter device, the receiver device and the chirp generator are integrated on a single chip.

BRIEF DESCRIPTION OF THE DRAWINGS

The invention will now be described in more detail and with reference to the appended drawings in which:

Figs. 1 and 2 are block diagrams of prior art;
Fig. 3 is a block diagram of an embodiment of the FMCW radar according to the present invention; and
Figs. 4 to 6 are block diagrams of embodiments of chirp generators.

DESCRIPTION OF EMBODIMENTS

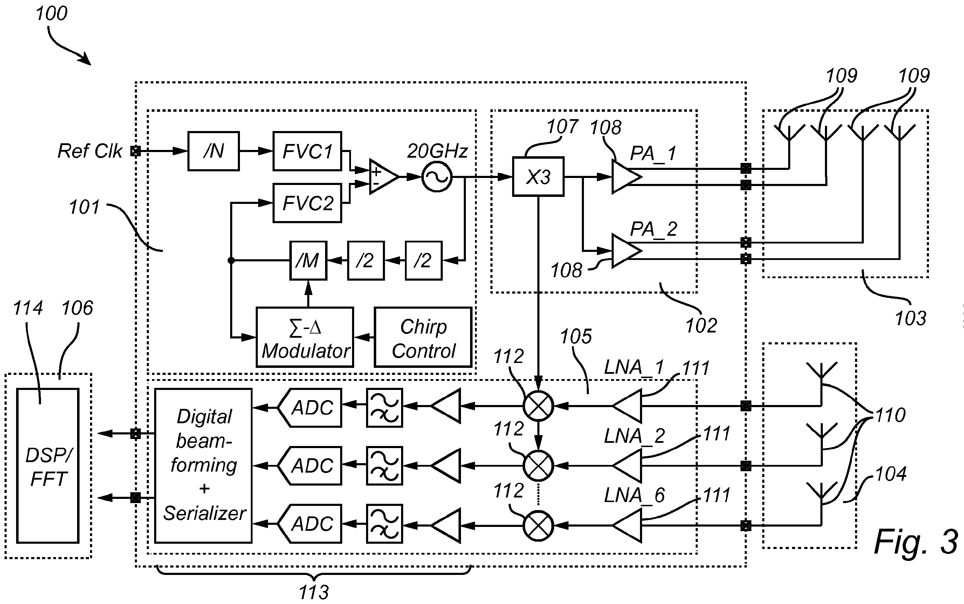

In accordance with a first embodiment of the FMCW radar, as shown in Fig. 3, the FMCW radar 100 comprises a chirp generator 101, a transmitter device 102, a transmit antenna device 103, a receive antenna device 104, a receiver device 105, and a signal processing device 106. The chirp generator 101 receives a reference clock as input signal, and is connected to the transmitter device 102 for providing it with an output signal to be transmitted by means of the transmit antenna device 103, connected to an output end of the transmitter device 102. The transmitter device 102 comprises frequency multiplication circuitry 107, and power amplification circuitry 108. The transmit antenna device 103 comprises multiple transmitting antennas 109, typically arranged as a transmit antenna array. The receive antenna device 104 comprises multiple receiving antennas 110, typically arranged as a receive antenna array. The receive antenna device 104 is connected to the receiver device 105, which comprises low noise amplifiers 111, receiving the antenna signals, frequency down converters 112, and signal pre-processing circuitry 113 arranged to filter the received signals, convert them to digital signals and apply digital beamforming on them. The receiver device 105 is connected to the signal processing device 106, which comprises digital signal processing (DSP) and Fast Fourier Transform (FFT) circuitry 114, and which is arranged to analyze the received signals in according to the application that the FMCW radar is used for. Common applications are distance and speed measurements.

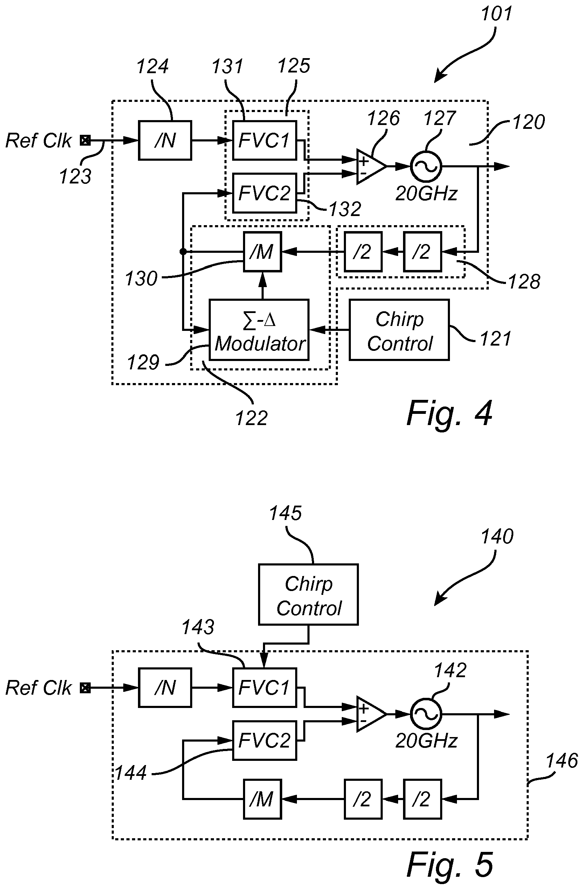

The chirp generator 101, as also shown in Fig. 4, comprises an FLL (Frequency Locked Loop) 120, and a chirp controller 121 connected with the FLL 120 to control the shape of the chirp. More particularly, according to this first embodiment of the FMCW radar 100, the chirp generator 101 comprises a Δ-Σ modulated frequency divider 122, a reference clock input 123, a reference frequency divider 124, a frequency to voltage converter 125, a differential voltage amplifier 126 a voltage controller oscillator (VCO) 127, and a VCO frequency divider 128. The Δ-Σ modulated frequency divider 122 comprises a Δ-Σ modulator 129 and a divide-by-M-frequency divider 130. The frequency to voltage converter 125 comprises a first frequency to voltage converter element (FVC1) 131 and a second frequency to voltage converter element (FVC1) 132. The chirp controller 121 typically comprises digital logic circuitry, and possibly state machines, to generate the chirp with a desired profile. Further, the chirp controller 121 can be provided with a number of predetermined settings for different chirp profiles.

The chirp generator 101 is operated in the following way. The reference frequency signal from the reference clock input 123 is divided by N and fed into the FVC1. An output signal from the Δ-Σ modulated frequency divider 122 is a scaled down, in frequency, replica of the output signal from the VCO 127, and is fed into the FVC2 132. The output signal of the FVC1 is a first reference voltage, which is proportional to the reference frequency, inversely proportional to the fixed division ratio N, and proportional to the gain of the FVC1 131. The first reference voltage is compared in the differential voltage amplifier 126 with a second reference voltage from the FVC2 132, which is thus proportional to the output frequency of the VCO 127, inversely proportional to the fixed division ratio of the VCO frequency divider 128, here 4, inversely proportional to the division ratio M of the Δ-Σ modulated frequency divider 122, and proportional to the gain of the FVC2 132. The output of the differential voltage amplifier 126 can be filtered by a loop filter (not shown in the figure) or connected directly to the VCO 127. In this way, a closed loop system is generated where the frequency from the VCO 127 is related to the reference frequency as shown in Equation 1 below. The gains from frequency to voltage of the two paths are denoted FVC1 and FVC2 respectively.

Equation 1:

$$f_{VCO} = f_{ref} * \frac{4M}{N} * \frac{FVC1}{FVC2}$$

The Δ-Σ modulated frequency divider 122 modulates the division ratio M. The chirp controller 121, which controls the Δ-Σ modulated frequency divider 122 can include several pre-defined Chirp profiles, e.g. Saw-tooth and triangular frequency ramp.

The FMCW radar 100 is generally operated as follows. The output signal of the VCO 127, having the chirp, is fed to the transmitter device 102, where it is frequency multiplied and amplified, and then fed to the transmit antenna device 103 to be transmitted as transmitted signals from the plural transmit antennas 109. Reflection signals are received at the receive antenna device 104 and then fed as received signals to the receiver device 105. At the receiver device 105 the received signals are amplified, down-converted, and pre-processed. Then, a final signal processing is performed by the DSP/FFT device 106 to generate the desired information, such as one or more of the distance to the object/objects reflecting the signal, and the speed at which an object containing the FMCW radar moves, or at which the reflecting object(-s) move.

In the FLL 101 the frequency of the VCO 127 is, thus, compared with the frequency of the reference frequency signal, which is different to a PLL where the phase of the VCO signal is compared with the phase of the reference frequency signal. Comparing phases gives a more accurate replica of the reference frequency and results in a higher quality signal from the VCO as regards the frequency drift, in particular when it comes to low frequency variations due to noise. However, the frequency drift has shown to be insignificant to the quality of the FMCW radar measurements. This is due to the use of the same clock in the transmitter device 102 as well as in the receiver device 105. An FLL is in general easier to implement than a PLL, which is why it provides significant advantageous in radar applications to generate the Chirp by means of an FLL.

A second embodiment of the FMCW radar has a slightly different chirp generator 140, as shown in Fig. 5. In comparison with the chirp generator 101 of the first embodiment, the $\Delta$-$\Sigma$ modulated frequency divider has been omitted from the FLL 146, and the input to the second frequency to voltage converter FVC2 144 has a fixed relation, here 4M, in frequency to the output frequency of the VCO 142. Instead, the modulation is applied on the gain of the first voltage to frequency generator 143. In other words, the chirp controller 145 is connected with the FVC1 143. However, as an alternative, the chirp controller 145 could be connected to the FVC2 144 instead. This implementation is less complex since it does not involve a $\Delta$-$\Sigma$ modulated frequency divider.

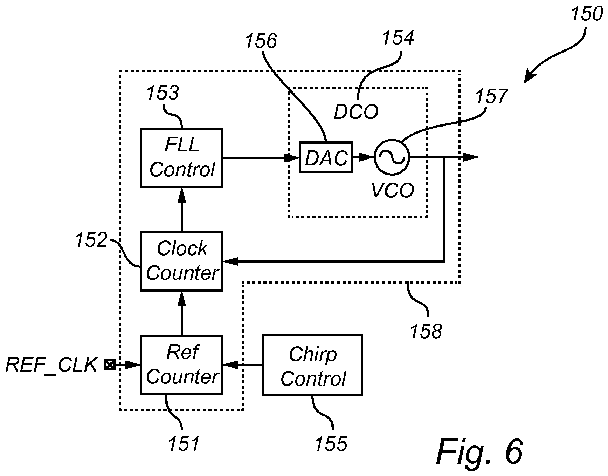

A third embodiment of the FMCW radar also has the same design as the first embodiment except for the chirp generator 150, shown in Fig. 6. This implementation is presently preferred, and is attractive since it includes very few analog blocks, and most of the implementation is carried out in the digital domain. The chirp generator 150 comprises an FLL 158, and a chirp controller 155. The FLL 158 comprises a reference counter 151, receiving the reference frequency, a clock counter 152 connected with the output of the reference counter 151, an FLL controller 153, connected with the output of the clock counter 152, a digitally controlled oscillator 154, having an input connected with the output of the FLL controller 153, and an output connected with the frequency counter 152, and a chirp controller 155, connected with an input of the reference counter 151. The DCO 154 comprises a digital to analog converter (DAC) 156, and a VCO 157. The only analog block, besides high frequency dividers which are in its function digital but in its implementation often to be considered as analog, is the DCO 154. The output signal from the VCO 157, which is the output signal of the chirp generator 150, is fed into the frequency counter 152 as well, which counts the number of pulses during a defined number of periods of the reference clock 151.

In this third embodiment, the chirp generator 150 operates as follows. The clock counter 152 counts pulses received from the VCO 157 during a time period determined by the reference counter 151, in order to determine the frequency. A correct frequency corresponds with a particular number of pulses counted during the time period. If the number of pulses becomes too few the frequency is too low. Then the logic circuitry of the FLL controller 153 changes the value of the DAC 156 such that the frequency is increased, while the value is changed in the other way if the number of pulses counted during the time period becomes too high.

Further alternatives to implement the FLL as such, which can be used in the chirp generator, are well described in literature and in scientific papers as will be understood by the person skilled in the art. In summary, a commonly used alternative to the approach described above is based on comparing clock pulses from the VCO during a certain number of clock periods of the reference clock. If the number of pulses are lower than the target value, the frequency from the VCO is too low, and the FLL control block increases the digital input to the DCO. By modulating the reference counter, the comparison time can be modified, which will generate a change in frequency at the output of the DCO. There are also other possible ways to modulate the output frequency of the DCO.

In all embodiments above it is possible to integrate at least some major parts of the FMCW radar 100 into a radio frequency integrated chip (RF-IC), i.e. to arrange them on a single chip. Those parts are at least the chirp generator 101, 140, 150, the transmitter device 102, and the receiver device 105. It is also possible to add the signal processing device 106 on the chip. For sake of completeness it should be mentioned that the RF-IC contains some further drive circuitry, as understood by the person skilled in the art, but that circuitry has been omitted in the drawings to focus them on the most relevant parts.

As mentioned above, the good phase noise performance of a PLL is not required in the FMCW radar. Hence, the simplicity of the FLL, when it comes to implementation complexity, is very attractive for a radar system. As can be seen in the various embodiments, it is possible to implement the FLL with mostly digital blocks, which is good for immunity against interferers as well as for power dissipation. Thus, some advantages of the FLL based chirp generator compared to a Fractional-N PLL based chirp generator are: less complex implementation; lower power dissipation; more robust and less sensitive for interferers; and smaller die area.

While the invention has been illustrated and described in detail in the drawings and foregoing description, such illustration and description are to be considered illustrative or exemplary and not restrictive. The invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. Any reference signs in the claims should not be construed as limiting the scope.

**Claims**

1.  A frequency modulated continuous wave radar comprising:

    - a transmitter device (102);
    - a receiver device (105); and
    - a chirp generator (101), connected with the transmitter device,

    wherein the chirp generator comprises a frequency locked loop (120), and a chirp controller (121) connected with the frequency locked loop to control the shape of the chirp.

2.  The frequency modulated continuous wave radar according to claim 1, wherein the frequency locked loop (120) comprises a $\Delta$-$\Sigma$ modulated frequency divider (122), and wherein the chirp controller (121) is connected with the $\Delta$-$\Sigma$ modulated frequency divider.

3.  The frequency modulated continuous wave radar according to claim 1, wherein the frequency locked loop (146) comprises a frequency to voltage converter (143, 144), and wherein the chirp controller (145) is connected with the frequency to voltage converter.

4.  The frequency modulated continuous wave radar according to claim 1, wherein the frequency locked loop (158) comprises a reference counter (151), which is arranged to receive a reference clock signal, and wherein the chirp controller (155) is connected with the reference counter.

5.  The frequency modulated continuous wave radar according to any one of the preceding claims, wherein at least the transmitter device (102), the receiver device (105) and the chirp generator (101) are integrated on a single chip.

Fig. 1

Fig. 2

Fig. 3

Fig. 4

Fig. 5

*Fig. 6*

Europäisches
Patentamt

European
Patent Office

Office européen
des brevets

# EUROPEAN SEARCH REPORT

Application Number

EP 17 20 2969

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | US 8 638 139 B2 (KEAVENEY MICHAEL [IE]; WALSH PATRICK [IE]; ANALOG DEVICES INC [US]) 28 January 2014 (2014-01-28) | 1,2,5 | INV.<br>G01S7/03<br>G01S7/35 |
| Y | * the whole document * | 3,4 | G01S13/34<br>H03L7/08 |
| X | EP 1 610 147 A1 (BOSCH GMBH ROBERT [DE]) 28 December 2005 (2005-12-28) | 1,5 | H03L7/097<br>H03L7/18 |
| Y | * paragraphs [0003] - [0005], [0009] - [0013]; figures 1-5 * | 2-4 | H03L7/181 |
| Y | US 2009/033376 A1 (LESSO JOHN PAUL [GB]) 5 February 2009 (2009-02-05)<br>* paragraphs [0016] - [0022]; figure 3 * | 2 | ADD.<br>G01S7/02 |
| Y | US 7 741 928 B1 (COUSINARD DAVID [CH] ET AL) 22 June 2010 (2010-06-22)<br>* column 2, lines 41-43 *<br>* column 5, line 52 - column 6, line 3; figure 4 *<br>* column 8, line 17 - column 9, line 25; figure 8 *<br>* column 11, line 5 - column 12, line 36; figure 11B *<br>* column 12, line 56 - column 13, line 50; figure 13 * | 3 | TECHNICAL FIELDS SEARCHED (IPC)<br><br>G01S<br>H03L |
| Y | US 6 111 471 A (BONNEAU DOMINIQUE [FR] ET AL) 29 August 2000 (2000-08-29)<br>* column 2, line 66 - column 3, line 64; figure 1 * | 4 | |
| Y | US 2008/231375 A1 (WELZ JARED [US] ET AL) 25 September 2008 (2008-09-25)<br>* paragraphs [0035] - [0038]; figure 4B * | 4 | |
| Y | US 2004/056724 A1 (ARP RONALD [US]) 25 March 2004 (2004-03-25)<br>* paragraphs [0016] - [0023]; figure 2 * | 4 | |

-/--

The present search report has been drawn up for all claims

| Place of search | Date of completion of the search | Examiner |
|---|---|---|
| Munich | 28 June 2018 | Schmelz, Christian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 17 20 2969

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2012/001658 A1 (KIM CHUL WOO [KR] ET AL) 5 January 2012 (2012-01-05) <br> * paragraphs [0057] - [0067] * <br> ----- | 2,3 | |

TECHNICAL FIELDS
SEARCHED      (IPC)

The present search report has been drawn up for all claims

| Place of search | Date of completion of the search | Examiner |
|---|---|---|
| Munich | 28 June 2018 | Schmelz, Christian |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 17 20 2969

This annex lists the patent family members relating to the patent documents cited in the above-mentioned European search report.
The members are as contained in the European Patent Office EDP file on
The European Patent Office is in no way liable for these particulars which are merely given for the purpose of information.

28-06-2018

| Patent document cited in search report | | Publication date | Patent family member(s) | | Publication date |
|---|---|---|---|---|---|
| US 8638139 | B2 | 28-01-2014 | NONE | | |
| EP 1610147 | A1 | 28-12-2005 | DE | 102004051276 A1 | 12-01-2006 |
| | | | EP | 1610147 A1 | 28-12-2005 |
| US 2009033376 | A1 | 05-02-2009 | GB | 2451476 A | 04-02-2009 |
| | | | US | 2009033376 A1 | 05-02-2009 |
| US 7741928 | B1 | 22-06-2010 | NONE | | |
| US 6111471 | A | 29-08-2000 | NONE | | |
| US 2008231375 | A1 | 25-09-2008 | US | 2008231375 A1 | 25-09-2008 |
| | | | US | 2008232446 A1 | 25-09-2008 |
| | | | US | 2008232447 A1 | 25-09-2008 |
| | | | US | 2008232448 A1 | 25-09-2008 |
| | | | US | 2008232523 A1 | 25-09-2008 |
| | | | US | 2008233869 A1 | 25-09-2008 |
| | | | US | 2008233881 A1 | 25-09-2008 |
| | | | US | 2008233882 A1 | 25-09-2008 |
| | | | US | 2008233883 A1 | 25-09-2008 |
| | | | US | 2008233890 A1 | 25-09-2008 |
| | | | US | 2008233897 A1 | 25-09-2008 |
| | | | US | 2008233900 A1 | 25-09-2008 |
| | | | US | 2008233907 A1 | 25-09-2008 |
| | | | US | 2008233911 A1 | 25-09-2008 |
| | | | US | 2008233954 A1 | 25-09-2008 |
| | | | US | 2010279633 A1 | 04-11-2010 |
| | | | US | 2011171916 A1 | 14-07-2011 |
| | | | US | 2011183628 A1 | 28-07-2011 |
| | | | US | 2012021706 A1 | 26-01-2012 |
| US 2004056724 | A1 | 25-03-2004 | GB | 2394608 A | 28-04-2004 |
| | | | US | 2004056724 A1 | 25-03-2004 |
| US 2012001658 | A1 | 05-01-2012 | KR | 20120002210 A | 05-01-2012 |
| | | | US | 2012001658 A1 | 05-01-2012 |

EPO FORM P0459

For more details about this annex : see Official Journal of the European Patent Office, No. 12/82

**EP 3 489 711 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8638139 B2

- US 8638139 B